(19) Europäisches Patentamt
European Patent Office
Office européen des brevets

(11) **EP 3 444 672 A1**

(12) **EUROPEAN PATENT APPLICATION**

(43) Date of publication:
**20.02.2019 Bulletin 2019/08**

(51) Int Cl.:
**G03F 7/00** (2006.01)

(21) Application number: **17306071.6**

(22) Date of filing: **16.08.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicants:
• **RHODIA OPERATIONS**
**75009 Paris (FR)**
• **LE CENTRE NATIONAL DE LA RECHERCHE SCIENTIFIQUE**
**(CNRS)**
**75794 Paris, Cedex 16 (FR)**

• **UNIVERSITE DE BORDEAUX**
**33000 Bordeaux (FR)**

(72) Inventors:
• **PAVAGEAU, Betrand**
**33140 Villenave d'Ornon (FR)**
• **ROMASANTA, Laura**
**33000 Bordeaux (FR)**
• **LENG, Jacques**
**33000 Bordeaux (FR)**

(74) Representative: **Delenne, Marc**
**Rhodia Services**
**Direction de la Propriété Industrielle**
**40, rue de la Haie-Coq**
**93306 Aubervilliers Cedex (FR)**

(54) **MICRO-PATTERNING OF HIGH CONDUCTIVE POLYMER**

(57)     A method for providing highly conductive tracks in a film of conductive polymer comprising :
(a) Providing a film of conductive polymer on a substrate, said film having a first surface;
(b) applying a stamp having a second surface to the first surface wherein the second surface comprises impressed microchannels;
(c) applying fluid capable of enhancing conductivity of conductive polymer to the microchannels;
(d) letting fluid diffuse through the film of conductive polymer;
(e) removing excessive fluid.

Figure 1

EP 3 444 672 A1

**Description**

This invention relates to a method for locally patterning film of conductive polymer in order to design tailor conductive tracks on an initially barely conductive polymer film deposited on any kind of substrate.

The conductive polymer of PEDOT:PSS [poly(3,4-ethylenedioxythiophene), PEDOT, complexed with polystyrene sulfonic acid, PSS], for example, has been considered for application to transparent touch screens or display electrodes because polymers have high mechanical strength, high conductivity, high transparency, and a variety of functionalities. Indium tin oxide (ITO) has been used as a transparent electrode material for display-related electronic devices, but ITO cannot be applied to future flexible devices owing to its brittle nature. The conductive polymer of PEDOT:PSS can tolerate being bent at a large bending radius of 1 mm for thousands of times, enabling bendable devices. In addition, the polymer can be tuned to exhibit a conductivity and light transmittance almost as high as ITO's. Thus, PEDOT:PSS may be used for flexible transparent touch screens or display electrodes as a replacement for ITO in the future.

For the manufacture of e.g. display electrodes, conventional ITO or inorganic electrode films are patterned through photolithography and wet or dry etching. Conductive polymers films, such as PEDOT:PSS film, are also accessible to photolithographic micropatterning (cf. e.g. Takamatsu, S. et al., Scientific Reports 5 (2015), 15003; Pal, R.K. et al., Adv. Mater. 28 (2016), 1406 - 1412; Zhang S. et al., J. Mater. Chem. C 4 (2016), 1382-1385) but the conductive polymer of PEDOT:PSS is reported to lose its conductivity through conventional photolithographic processes. This is because the water-based developer in lithography washes out the PEDOT:PSS film and the cleaning alcohol used in lithography also dissolves the film. Further, photolithographic procedures may show photoresist decomposition due to the strong acidity of PEDOT:PSS solutions. The chemical etching/developing steps, post-fabrication procedures and the use of prefabricated masks increase the costs, processing times and chemical wastes.

Further methods for patterning conductive polymer thin film include screen printing (Microsyst. Technol. 19 (2013), 895 - 903), chemically controlled transfer printing (Kim, N. et al., Adv. Mater. 27 (2015), 2317 - 2323), inkjet or bubble jet printing (Xiong, Z. and Liu, C., Organic Electronics 13 (2012), 1532 - 1540; Sele, C.W. et al., Adv. Mater. 17 (2005), 997 - 1001), spray coating (Kim, S. et al., Organic Electronics 30 (2016), 296 - 301) or laser supported patterning (Semaltianos, N.G. et al, Synthetic Metals 161 (2011), 431 - 439). However, these methods either provide low resolutions and/or low conductivity or lack the economics required to apply them on an industrial scale.

In particular, ink jet printing techniques are prone to cause clogging of the jet nozzle (generally due to high viscosity of polymer solutions), thus decreasing the reliability for a continuous printing process. Moreover, features with sharply defined shapes and dimensions smaller than 10 $\mu$m are still difficult to achieve.

Spray coating techniques using shadow masks generally are not capable to pattern precise, intricate shapes.

Laser ablation patterning requires the uses of intense laser sources which can thermally damage the materials in the proximity to the irradiated area.

Thus, there still is a need for conductive polymer patterning techniques providing simple and high throughput and high conductivity (> 100 S.cm$^{-1}$).

It was thus an object of the present invention to provide a simple micro-patterning process producing highly conductive 2-dimensional (2D) conductive polymer tracks. Another object of the invention was to provide 3-dimensional (3D) shapes or designs by additive construction of the 2D method.

The objects are achieved by employing the microfluidics technique to locally tune the conductive properties of conductive polymer film. In accordance with claim 1, fluid capable of significantly enhancing the conductivity of conductive polymer (so-called secondary dopant) is applied to certain, well-defined zones of conductive polymer film that are exposed to the fluid.

Preferred embodiments are set forth in the dependent claims and in the detailed specification hereinafter.

The first aspect of the invention is the use of microfluidics in order to precisely control the contact in time and space of the secondary dopant with the conductive polymer film.

The term microfluidics, as used herein, refers to the behavior, precise control and manipulation of fluids that are geometrically constrained to a small, typically sub-millimeter, scale.

PEDOT:PSS thin films, for example, generally show conductivity values in the range of 10$^{-1}$- 10 S·cm$^{-1}$ which is far away from ITO conductivity values (normally around 1000 - 3000 S·cm$^{-1}$). Current accepted model for the morphology of PEDOT:PSS thin films is a lamellar structure, in which hydrophobic and conducting PEDOT nanocrystals are isolated by a thin shell of insulating PSS in the through-plane direction. The large amount of PSS present in commercial PEDOT:PSS dispersions lead to regions of PSS enrichment which are poor electrical conductors due to a lack of PEDOT charge transport sites, hence forming energetic charge barriers and limiting the conductivity. This issue is becoming the bottleneck for the development of purely organic-based devices.

Dopants may be employed to overcome said bottleneck.

The term secondary dopant, as used herein, refers to an additive that further increases the conductivity of an already doped polymer by up to several orders of magnitude. The main difference between primary and secondary doping is that the first has a reversible effect, whereas the effect of the latter is permanent and remains even when the additive is removed. In contrast, the term primary doping refers to the addition of small nonstoichiometric quantities of a material to conductive polymers that lead to a strong increase in conductivity of these polymers. This can be brought about by a redox agent that either oxidizes (p doping) or reduces (n doping) the polymer chain.

Secondary dopants may either be added directly to the conductive polymer stock solution or conductive polymer thin film may be post-treated by immersing the film into the aforementioned dopants for a certain time.

Any dispersion, solution or thin film of PEDOT based conductive polymer can be used to carry out the present invention. This includes, for example, PEDOT complexed with p-toluenesulfonate ($CH_3$-$C_6H_4$-$SO_3^-$), chloride ($Cl^-$), perchlorate ($ClO_4^-$), trifluoromethanesulfonate ($CF_3SO_3^-$), hexafluoro phosphate ($PF_6^-$), or polystyrene sulfonate ($-CH_2CH(C_6H_4SO_3)^-)_n$), the latter PEDOT based conductive polymer being referred to herein as PEDOT:PSS.

In a preferred embodiment of the invention, the conductive polymer is PEDOT:PSS.

In further preferred embodiments of the invention, the secondary dopant is a fluid, more preferably the secondary dopant is a liquid or a vapor.

A vast number of secondary dopants have already shown to effectively increase PEDOT:PSS electrical conductivity. Such secondary dopants belong to the group comprising :

- High boiling point solvents (e.g. dimethylsulfoxide, tetrahydrofurane, dimethylformamide, acetonitrile, nitromethane, pyridine, cyclohexanone)
- Alcohols (e.g. ethylene glycol, diethylene glycol, glycerol, methanol, 4-methoxyphenol)
- Ionic liquids (e.g. 1-ethyl-3-methylimidazolium tetracyanoborate; 2-methylimidazole; 1-ethyl-3-methylimidazolium tetrafluoroborate)
- Inorganic acids (e.g. sulfuric acid)
- Weak and mild organic acids (e.g. methane sulfonic acid)

Any of the above cited secondary dopants, mixtures or aqueous solutions of these dopants can be used in the micro-patterning process according to the invention. In a preferred embodiment of the invention, ethylene glycol (EG), dimethylsulfoxide (DMSO), or 1-ethyl-3-methylimidazolium tetracyanoborate (EMIM-TCB) are employed as the secondary dopant.

In another preferred embodiment of the invention, PEDOT:PSS thin film deposited on a substrate is locally modified using a stamp patterned by standard soft photolithographic technique.

Preferably, for carrying out the present invention, commercially available PEDOT: PSS aqueous solution or dispersion is being used bearing a solid content of from 0.1 - 10 weight- %, preferably 0.3 - 5 weight- %, more preferably 0.5 - 2.5 weight- %, most preferably 0.8 - 1.5 weight- %. The viscosity of the solution or dispersion ranges from 1 - 100 mPa·s, preferably 5 - 75 mPa·s, more preferably 10 - 60 mPa·s, most preferably 15 - 50 mPa·s. The PEDOT:PSS weight ratio of such solution or dispersion ranges from 1:0.5 to 1:30. Ratios of 1:1 to 1:4 are preferred.

In a preferred embodiment of the invention, the aqueous PEDOT:PSS-based solution or dispersion is sonicated and filtered before further use.

Depending on the thickness and size of the conductive area required, PEDOT:PSS thin film can be obtained by various deposition techniques such as roll-to-toll, doctor blading, spin coating, etc. onto many different types of substrates (e.g. glass, metal foil, or polymer film, such as polyester film, or polysiloxane film). Spin coating is the preferred deposition technique.

The substrate onto which PEDOT:PSS film is to be deposited must be thoroughly wetted with the aqueous polymer solution or dispersion and may require prior treatment. Glass substrates are preferably pre-conditioned at temperatures of from 40°C - 80°C by ultrasonic cleaning in deionized water comprising detergent, rinsed with deionized water and subsequently ultrasonically cleaned in acetone at 40°C - 60°C and ethanol at 40°C - 60°C. Subsequently, the glass substrates' surface is activated by soft air plasma treatment (preferably at 100 W for 10 minutes) to enhance wettability.

A first single layer of PEDOT:PSS may be obtained by spin coating. Preferably, 5 - 20 $\mu$l, most preferably 10 - 15 $\mu$l of the aqueous PEDOT:PSS solution or dispersion are used per $cm^2$ of the surface at spinning speeds of 300 - 3000 rpm, preferably 500 - 1500 rpm for 30 - 90 s. The thickness of such first layer typically ranges from 70 to 130 nm.

PEDOT:PSS thicker layers may be obtained by stacking single layers, namely by repeating the spin coating process multiple times in order to reach a desired thickness. After the first stage, preferably all subsequent spin-coating stages are performed with 20 - 30, most preferably 23 - 27 $\mu$L/$cm^2$ at 500 - 4000 rpm, preferably 1500 - 2500 rpm for 30 - 90 s.

In a preferred embodiment, in between two spin-coating steps the deposited layer is dried at 100 - 140°C for 10 - 30 min in order to remove any residual water and subsequently exposed to soft air plasma treatment (preferably at 10 - 75 W for 5 - 20 s) to enhance wettability.

The thickness of two stacked layers typically ranges from 140 to 250 nm. The thickness of eight stacked layers typically ranges from 400 to 500 nm.

In a further preferred embodiment of the invention, the employed stamp consists of a PDMS (polydimethylsiloxane) block with impressed channels, hereinafter referred to as microchannels, that have been created e.g. by soft photolithographic technique.

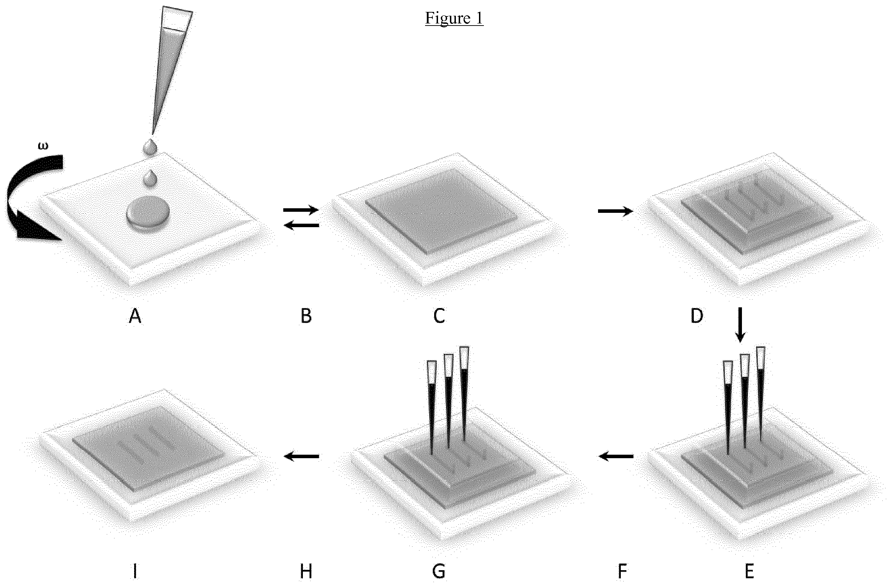

In a yet further preferred embodiment, each microchannel is equipped with an inlet and an outlet (e.g. holes punched in the PDMS matrix) for introducing and recovering the secondary dopant, respectively, as depicted in Figure 1. The microchannels' depth ranges from 10 to 100 $\mu$m, preferably from 30 to 70 $\mu$m. The microchannels' width ranges from 100 - 5000 $\mu$m, preferably from 1000 to 2000 $\mu$m. The microchannels' length ranges from 0.3 - 5 cm, preferably from 0.5 to 1.5 cm.

In a further preferred embodiment of the invention, the stamp is plasma treated to enhance adhesion with the thin film and subsequently deposited onto the PEDOT:PSS film and thereby preventing dopants' leakage. Preferably, a soft air plasma treatment is employed (e.g. at 40 W for 10 s) to enhance adhesion. Each microchannel inlet is connected to the respective dopant reservoir (e.g. by PFTE tubing to a syringe needle) to receive the various dopants. After filling the microchannels, as post-treatment the dopants are let to diffuse through the PEDOT:PSS thin film for a period of time which can vary between seconds to hours. Immediately after the post-treatment, the dopants are removed through the outlet by gently pushing air into the microchannel, and the surface is dried at e.g. 120°C for 5 - 45 min. Subsequently, deionized water is flushed into the microchannels for about 1 minute to remove any possible traces of dopants and again dried at e.g. 120°C for 5 - 45 min. Finally, the stamp is peeled off from the PEDOT:PSS thin film, leading to PEDOT:PSS thin film with virtual and tailor lanes that exhibit a 2 to 3 orders of magnitude increase of conductivity as compared with the pristine layer.

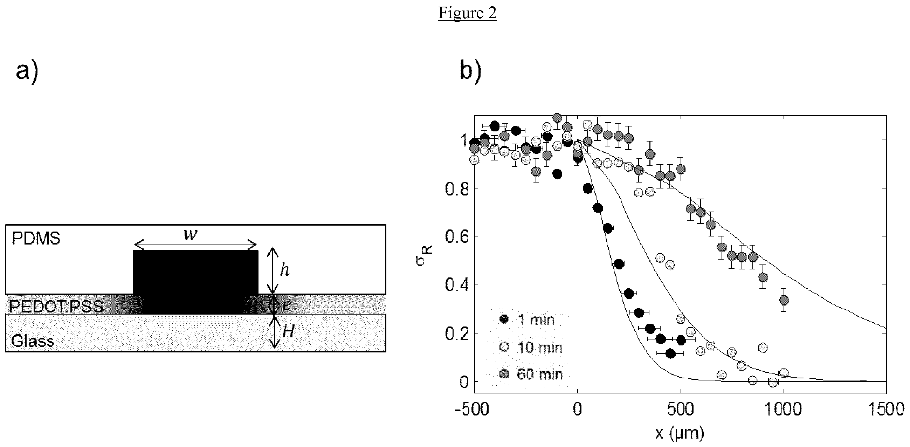

The modification of the film's conductivity stems from diffusion of the dopant from the microfluidic microchannel into the PEDOT:PSS thin film. Such diffusion process involves two very different timescales : first, dopants diffuse vertically within the thickness of the film only where it is exposed (i.e. underneath the microfluidic microchannel); subsequently, molecules diffuse horizontally underneath the stamp. For thin films of a thickness (e) < 300 nm, the first diffusion stage is fast (diffusion time $\tau \sim e^2/D < 10^{-2}$ s with $D \approx 10^{-11}$ m$^2$/s$^{-1}$ being a typical diffusion coefficient of a molecule into a polymeric film) whereas the second stage is unsteady leading to a spreading of the dopant within the film on a spatial extent outside the patterning zone, as illustrated in Figure 2.

In general, faster treatment will lead to better resolution. Since samples with either large or small post-treatment times exhibit similar electrical conductivity values underneath the microchannels, in terms of up-scaling a flash post-treatment (for a few seconds) appears the most appealing.

The control of post-treatment time can be of importance when high resolution patterns are required although a significant spreading of dopant will not be deleterious to the accuracy of patterning in terms of electrical conductivity, probably because of the very nonlinear relationship between conductivity and the amount of dopant.

Given the vast number of available and potentially new secondary dopants prone to increase PEDOT:PSS electrical conductivity, the post-treatment strategy according to the invention can also be used as a fast and easy screening tool to check the influence of dopants on PEDOT:PSS morphological and electrical properties. The patterning technique according to the invention was used as such screening tool to select the most efficient secondary dopant among the above named secondary dopants of the preferred embodiment, namely ethylene glycol (EG), dimethyl sulfoxide (DMSO), and 1-ethyl-3-methylimidazolium tetracyanoborate (EMIM-TCB), revealing that EG is the best conductivity booster of the three tested secondary dopants.

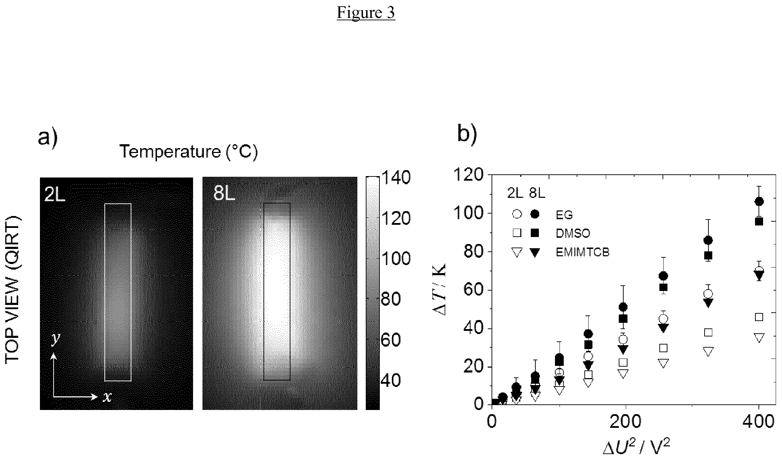

The patterned structures created employing the present post-treatment approach are also suitable as heaters, in the following referred to as microheaters, and their performance can be characterized considering classical ohmic law (V=I·R). The electro-thermal performance of the PEDOT:PSS patterns can be examined by using far field Quantitative Infra-Red Thermography (QIRT) under ambient conditions applying a direct voltage (V) ramp, e.g. from 0 to 20 volts. The application of such external voltage induces the heating of the post-treated structures (see Figure 3a), whereas the pristine, untreated PEDOT:PSS film does not show any increase in temperature even when applying 20 volts. Rather, at voltages exceeding 16 volts, current intensity decreases with increasing voltage, evidencing a loss of electrical conductivity and probably an irreversible damage due to an over-oxidation process.

QIRT analysis of the temperature increment $\Delta T$ above room temperature (TO) measured at steady state in the middle of each lane follows $\Delta T \propto V^2$, supporting a heating via Joule's effect (Figure 3b).

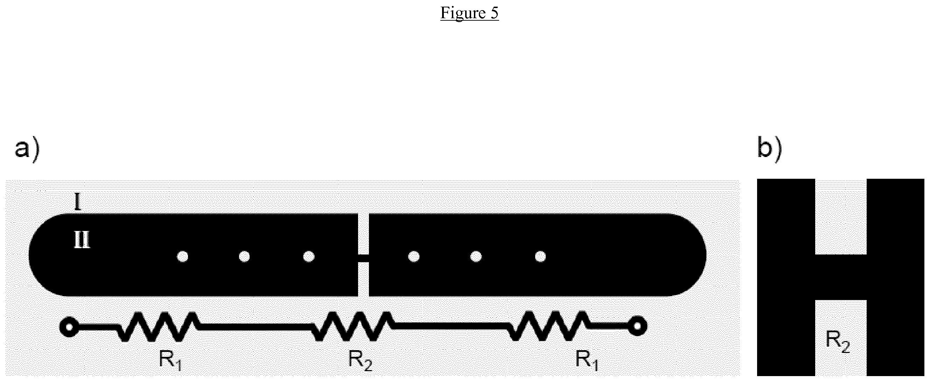

The spatial temperature distribution and the steady state temperature achievable with the patterned structures according to the invention can be controlled by selecting the pattern's design and substrate's thickness and thermal conductivity, thus enabling heat manipulation "on demand" when specific heating or non-uniform heating is required. Full benefit of the intrinsic integration capacities of the patterning technique of the invention can be taken to engineer on demand solution-based, low-cost, and efficient localized heaters (referred to as $\mu$-heaters) for microfluidics. They are designed by electrical analogy where resistors are e.g. connected in series (see Figure 5), the highest one ($R_2 \gg R_1$) generating the highest Joule's effect. The exemplary design of Figure 5 may be patterned with a stamp featuring a constriction. The design of the constriction $R_2$ (Figure 5b) in the center of Figure 5a permits to engineer a heat source delivering up to 150°C on the upper surface on a 2L PEDOT:PSS thin film.

The heaters can also be engineered as defoggers on large scale windows - using basic printing technologies - with 90 to 95 % transparency in the visible range.

Thus, the patterning technique of the invention opens several interesting perspectives : first, the localized patterning of conductive zones in thin films of PEDOT:PSS can be widely tuned with, for instance, continuous printing or patterning techniques, on any type of substrate including flexible ones. Up-scaling is therefore possible not only in terms of substrate size but also in terms of processing and of screening method. Further, the developed method for assessing the heating power of a thin film using infra-red thermography can be used as such to quantify the performances of the many different formulations of conductive films that appear nowadays in literature.

Eventually, integration of low-cost conductive constructs into micro-devices seems straightforward and could possibly be extended to 3D structures.

In summary, the post-treatment geometry defined within the stamp can be totally designed according to the needs and the final application desired. Not only simple line patterns (with individual widths down to 250 $\mu$m) can be developed with this technique but also more complex structures with intricate shapes (see e.g. Figure 5) can be patterned with high resolution. With standard soft lithography technique and plastic (low cost) masks, patterns of about 5-10 $\mu$m can be reached routinely. More precise patterning is possible (sub micrometer) through the use of metal-based (higher cost) masks.

The main strength of the post-treatment method of the present invention is that it preserves the colloidal stability of PEDOT:PSS solutions. The addition of secondary dopants to PEDOT:PSS solutions may bring about drawbacks that encompass changes in the viscosity and surface tension. These changes might have a direct impact on PEDOT:PSS colloidal stability and may induce, for instance, the clogging of print-head nozzles due to the agglomeration of the ink formulation particles. Even the formation of an homogeneous thin film from an agglomerated dispersion using standard film casting processes may not be possible.

Another strength of the post-treatment method of the present invention is that it avoids any post-processing procedures that could damage the films. Further, it is compatible with current solution-based printing techniques in industry and it is easily scalable for larger areas with conventional printing technologies such as gravure printing, etc. but also with digital printing (such as ink-jet printing) by sequentially printing PEDOT:PSS and the secondary dopant.

The patterning technique of the invention also has strong potential to be applied for reactive liquid deposition patterning of PEDOT:PSS. Using the technique, the oxidant "ink" (generally iron (III) p-toluenesulfonate in butanol) could be deposited on the target substrate so that, when exposed to EDOT monomer in a vapor phase polymerization chamber, each deposited feature would localize the synthesis of conducting PEDOT-based structures.

Other functionalities could also be enhanced locally by following the technique of the invention, e.g. by simply injecting a targeted solvent into the microchannels such that only select areas of the substrate are in contact with the solvent. Examples could be micro-structuration of cellulose films by enzymatic activity, microscale patterning of thermoplastic surfaces by exposing selectively the surface to a suitable organic solvent. The method of the invention also has potential to produce complex polymeric microstructures by photochemical thermal micromoulding of polymers or even for the development of microstructured conductive hydrogels by sequentially printing the precursors.

Figure Legend

Figure 1 :   Schematic representation for PEDOT:PSS post-treatment using the stamp technique.

Step A : PEDOT:PSS spin coating on glass substrate (12.5 $\mu$l/cm$^2$)
Step B : Annealing for 15 min
Step C : Repeat spin coating to build 2 or 8 layers (height 100 or 300 nm, respectively)
Step D : Apply PDMS stamp bearing microchannels of the following dimensions : height : 50 - 60 $\mu$m, width : 1500 $\mu$m, length : 1 cm.
Step E : Fill microchannels with dopants and let diffuse (room temperature for 1 - 60 min)
Step F : Remove dopants and anneal
Step G : Clean microchannels with deionized water
Step H : Anneal and remove stamp
Step I : PEDOT:PSS patterned thin film with highly conductive tracks

Figure 2 :   (a) Sketch of post-treatment geometry showing dopant's lateral diffusion into the PEDOT:PSS thin film.
(b) Raman microspectroscopy mapping of the normalized relative red shift for PEDOT:PSS thin film post-treated with EG for different exposure times; x < 0 represents the zone underneath the microfluidic micro channel whereas x> 0 is a zone underneath the stamp. The solid lines represent the solution of a unidirectional diffusion process (in the x direction); with a source of dopant in the fluidic channel, including a plasticizing effect described with a concentrationdependent diffusion coefficient.

Figure 3 :    (a) Examples of QIRT images of locally post-treated PEDOT:PSS films with two different thicknesses (2L = 2 layers ≈ 100 nm, 8L = 8 layers ≈ 300 nm) undergoing Joule's heating under 20V DC. The dimensions of the microchannel employed for the post-treatment are highlighted.
   (b) Temperature increment $\Delta T = T\text{-}T0$ in the middle of the lane at the surface of the film during heating experiments against the applied voltage, where $T0$ stands for room temperature and 2L and 8L are for films of different thicknesses and for post-treatment with three different dopants (ethylene glycol (EG), dimethyl sulfoxide (DMSO), EMIM-TCB).

Figure 4 :    Raman spectra for pristine and post-treated (EG, DMSO, EMIM-TCB) PEDOT:PSS thin film showing the peak corresponding to PEDOT thiophene rings. The arrow indicates the red Raman shift displayed for post-treated thin film.

Figure 5 :    Pattern of 2L film obtained using PEDOT:PSS post-treatment by microfluidic stamp. (a) Length = 19 mm, width = 2000 $\mu$m; (b) magnification of center of (a), width = 200 $\mu$m; I : pristine portion of PEDOT:PSS film, II : post-treated portion of film.

The following examples describe preferred embodiments of the invention : Examples :

1. Preparation of PEDOT:PSS thin films

PEDOT:PSS aqueous dispersion Clevios PH 1000 available from Haereus Clevios GmbH, having a solid content of 1 weight- % and a PEDOT:PSS ratio of 1:2.5 was employed for the experiments.

Prior to use, the aqueous dispersion was placed in an 8 ml glass vial and sonicated for 1h at room temperature and then filtered through a 0.45 $\mu$m PVDF syringe filter mounted on a plastic syringe.

Glass substrates were ultrasonically cleaned in deionized water with detergent (10 minutes at 60°C), rinsed thoroughly with deionized water and then ultrasonically cleaned in acetone (5 minutes at 60°C) and ethanol (5 minutes at 60°C). The glass substrates' surface was then activated by air plasma treatment (100 W for 10 minutes, using an Atto Plasma Cleaner from Diener electronic GmbH + Co. KG) to enhance wettability.

The first single layer of PEDOT:PSS was obtained by spin coating (Spin150 from SPINCOATING) 12.5 $\mu$l/cm$^2$ of the aqueous dispersion at 1000 rpm for 60 s onto glass. PEDOT:PSS thicker samples were obtained by stacking single layers, i.e. by repeating the spin coating process multiple times in order to reach a desired thickness. After the first stage, all subsequent spin-coating stages were performed with 25 $\mu$l/cm$^2$ at 2000 rpm for 60 seconds.

In between two spin-coating steps, the deposited layer was dried at 120°C for 15 min and exposed of a soft air plasma treatment (40 W for 10 s) to enhance wettability.

2. PEDOT:PSS post-treatment using stamps

PEDOT:PSS thin films according to Example 1 were locally modified by using a PDMS-based stamp patterned by standard soft photolithography technique using SU-8 3050 photoresist (MicroChem. Corp.) as follows :

-   Silicon wafer substrates used for the fabrication of SU-8 photoresist masters were first cleaned with isopropyl alcohol (IPA) followed by drying with a nitrogen stream. A volume of, approximately, 10 ml of SU-8 3050 photoresist was placed on the center or the substrates and deposited using a spin-coater (Spin150, SPINCOATING). The spin coating process was performed in two cycles : a cycle set at a rotational speed of 500 rpm for 10 s using an acceleration of 300 rpm/s followed by a cycle at 3000 rpm for 30 s at acceleration of 300 rpm/s during a time of 30 s.
-   Photoresist-coated substrates were then soft baked for 20 m at 95°C using a hot plate (SAWATEC) to evaporate slowly the solvent thus improving the adhesion of the photoresist with the substrates.
-   Once cooled to room temperature, photoresist-coated substrates were placed in contact with the photomasks (previously designed using CLEWIN software and printed onto transparent plastic sheets) so that the side of the ink was in contact with the photoresist. A glass plate was then placed on top of the photomask and the whole sample was deposited on a mask aligner (MJB4, SUSS MICROTECH). This equipment has an air suction system that allows creating a vacuum zone and, therefore, a better contact between the mask and the photoresist-coated substrate. The exposure time used (11 s) at 365 nm was determined using Equation 1 and taking into account both the light intensity of the equipment (35 mW/cm$^2$) and the exposure energy detailed in MicroChem datasheets.

$$Exposure\ time = \frac{Exposure\ Energy\ \left(\frac{mJ}{cm^2}\right)}{Light\ intensity\ \left(\frac{mW}{cm^2}\right)} \qquad \text{(Equation 1)}$$

- After UV exposure, samples were post-baked on a hot plate for 4 min at 95°C to increase the degree of crosslinking in the irradiated area, cooled down to room temperature and immersed in propylene glycol mono methyl ether acetate (PGMEA) during 8 min for removing non-exposed SU-8. After that, photoresist master samples with microstructures having average height h =50-60 $\mu$m were rinsed with IPA and dried with a nitrogen beam.
- Photoresist master samples were finally placed on a hot plate at 95°C for 10 min along with a vial coating few droplets of hexamethyldisilazane (HMDS) to decrease the surface free energy of the SU-8 microstructures which facilitates the later removal of the PDMS replica from the photoresist master.

PDMS stamps with thicknesses around 5 mm were then prepared as follows :

- A mixture of PDMS prepolymer and its curing agent (Sylgard®184, DOW CORNING) was prepared in a ratio of 10:1 by weight, mixed thoroughly and placed under vacuum in a vacuum desiccator until gas bubbles were removed from the mixture.
- The liquid mixture of PDMS and curing agent was then poured over the photoresist master and cured at 60°C for 3-4 h to obtain an elastomeric solid material.
- A PDMS stamp was finally obtained by cutting with a scalpel around the features and manually peeling it off the master.

For the post-treatment method disclosed herein, the PDMS stamp has several impressed microchannels where each of them is equipped with an inlet and an outlet (holes punched in the PDMS stamp) for introducing and recovering dopants, respectively. The PDMS stamp is deposited carefully onto the PEDOT:PSS film after treating the former with a soft (40W for 10 s) air plasma (Atto Plasma Cleaner from Diener electronic GmbH + Co. KG). Each microchannel inlet is connected to a syringe needle by PFTE tubing to pump the individual dopants (EG, DMSO and EMIM-TCB). After filling the microchannels, dopants are let to diffuse through the PEDOT:PSS thin film for a period of time. Immediately after this treatment, dopants are removed through the outlet by gently pushing air into the microchannel and dried at 120°C for 15 min. Thereafter, deionized water is flushed into the microchannels for about 1 minute to remove any possible traces of dopants and again dried at 120°C for 15 min. Finally, the elastomeric stamp is peeled off the PEDOT:PSS thin film, leading to PEDOT:PSS thin film with virtual and tailor lanes.

3. Characterization of post-treated PEDOT:PSS areas

3.1 Raman Microspectroscopy

Raman spectroscopic measurements were recorded using a confocal Raman microscope (HR800 from Horiba Jobin Yvon) with a 532 nm excitation laser, a x20 objective lens (NA=0.25) and 1800 lines per millimeter grating. Using this configuration, Raman spatial and spectral resolution was around 2.5 $\mu$m and 0.2 cm$^{-1}$, respectively. Mapping measurements were performed using the same configuration detailed above by steps of 50 $\mu$m.

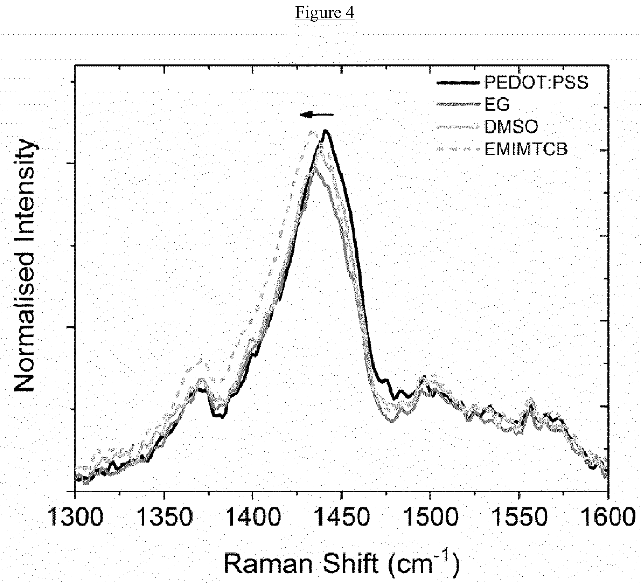

A. For the three different post-treatments, Raman microspectroscopy was used to characterize the conformational change of the resonant structure of PEDOT chains, from the benzoid (1453 cm$^{-1}$) in pristine PEDOT:PSS to the quinoid (1425 cm$^{-1}$) structure in the post-treated areas (see Figure 4). In all the post-treated PEDOT:PSS microchannels, the band located between 1400 and 1500 cm$^{-1}$ displayed a slight red Raman shift, from 1440 cm$^{-1}$ to 1434 cm$^{-1}$, indicating that all post-treatments favor PEDOT expanded coil conformation and hence, and ordered chain rearrangement. The addition of the dopants can weaken the coulombic attraction between PEDOT and PSS chains, so that PEDOT chains rearrange from coiled to linear conformation. This rearrangement is also enhanced by the plasticizing effect of the dopant on the PSS polymeric material. In this favored conformation, the neighboring PEDOT thiophene rings are oriented almost in the same plane which enables the delocalization of the conjugated $\pi$-electrons over the whole thus increasing the charge-carrier mobility while the inter-chain interaction among the PEDOT chains increases at the same time.

B. Lateral or in-plane diffusion of EG dopant was followed by tracking the conformational change of PEDOT thiophene ring along a line perpendicular to the pristine/EG post-treated PEDOT:PSS interface after three different post-treatment times (1 min, 10 min and 1 hour). Raman spectra shown in Figure 2b have been normalized with respect to the Raman shift inside and outside the microchannel. All samples show that inside the microchannel (x<0) the quinoid conformational structure is favored, whereas towards outside the microchannel (x>0), the benzoid conformational structure is preferred, thus evidencing a diffusion gradient of EG over the distance. The diffusion profiles show that EG diffusion present a chemical front and that it propagates through PEDOT:PSS film over the time. The progressive uptake of EG could impact the structure of PEDOT:PSS films thus facilitating an enhanced diffusion, similar to the diffusion of solvents into glass polymers, where a sufficient accumulation of a chemical moving front causes polymer relaxation and swelling.

3.2 Electrical Conductivity

The conformational change observed by Raman spectroscopy was accompanied by 25 - 30 % decrease in the films' thicknesses, likely due to the removal of hydrophilic PSS shell around the PEDOT grains, inducing PSS segregation. This enhanced percolating network of PEDOT-rich grains through the film can allow low-barrier electron hopping, thus resulting in an increment of the electrical conductivity around 2 orders of magnitude higher as shown in Table 1.

**Table 1.** Electrical conductivity values for the different post-treatments using pristine PEDOT:PSS films with different thicknesses (2 (2L) and 8 (8L) layered films)

| Dopant | Conductivity ($S \cdot cm^{-1}$) (2L PEDOT: PSS) | Conductivity ($S \cdot cm^{-1}$) (8L PEDOT: PSS) |
|---|---|---|
| Ethylene glycol (EG) | $955 \pm 47$ | $920 \pm 73$ |
| Dimethylsulfoxide (DMSO) | $830 \pm 35$ | $890 \pm 13$ |
| EMIMTCB | $880 \pm 32$ | $522 \pm 25$ |

Moreover, samples with either large or small post-treatment times exhibit similar electrical conductivity values underneath the microchannel (see Table 2).

**Table 2.** Electrical conductivity values for PEDOT:PSS doping with ethylene glycol using different post-treatment times and pristine PEDOT:PSS films with different thicknesses (2 (2L) and 8 (8L) layered films).

| Post-treatment time (minutes) | Conductivity ($S \cdot cm^{-1}$) (2L PEDOT: PSS) | Conductivity ($S \cdot cm^{-1}$) (8L PEDOT: PSS) |
|---|---|---|
| 1 | $1002 \pm 81$ | $857 \pm 12$ |
| 10 | $955 \pm 47$ | $920 \pm 73$ |
| 60 | $903 \pm 75$ | $862 \pm 23$ |

3.3 Joule's Microheaters

The transduction of electrical energy into heat, known as Joule effect or resistive heating, is defined as the process by which the passage of an electrical current in a conductor is converted to heat through resistive losses in the material. This amount of heat produced, or Joule heating power, is proportional to the square of the amount of current I that is flowing through the material when its electrical resistance R and the time of current flow is constant. Considering an Ohmic conductor, where V = IR, this equation can be modified as follows (Equation 2) :

$$q = I^2R = V^2/R \qquad (Equation\ 2)$$

which implies that Joule power increases when the material resistance decreases for a fixed sample geometry. The ohmic character of all the different post-treated PEDOT:PSS samples was verified during the thermal experiments, where it was found a linear relationship between the input voltage and the current intensity.

PEDOT:PSS post-treated microchannels were connected with silver paint to a DC power supply (Keithley 2400) and a voltage ramp was applied between 0 and 20 volts, each step for a period of 90 seconds.

The 2D temperature distribution images were captured in real time by a FLIR7000 infrared thermocamera (equipped with a MWIR 50 mm lens) and recorded with Matlab software. Temperature calibration was previously performed using a thin (80 $\mu$m diameter) K-type thermocouple connected to a digital thermometer and to the post-treated PEDOT:PSS microchannels using a thermal paste. All temperature measurements were performed at room temperature under a fume hood with low air extraction.

**Claims**

1. A method for providing highly conductive tracks in a film of conductive polymer comprising :

   (a) Providing a film of conductive polymer on a substrate, said film having a first surface;
   (b) applying a stamp having a second surface to the first surface wherein the second surface comprises impressed microchannels;
   (c) applying fluid capable of enhancing conductivity of conductive polymer to the microchannels;
   (d) letting fluid diffuse through the film of conductive polymer;
   (e) removing excessive fluid.

2. A method as claimed in claim 1 wherein the conductive polymer is PEDOT:PSS.

3. A method as claimed in claim 1 or 2 wherein the substrate material is glass, metal foil, or polymer film.

4. A method as claimed in any of claims 1 to 3 wherein the stamp consists of polydimethylsiloxane (PDMS).

5. A method as claimed in any of claims 1 to 4 wherein the microchannels have been created by photolithographic techniques.

6. A method as claimed in any of claims 1 to 5 wherein the microchannels have a depth ranging from 10 to 100 $\mu$m, preferably from 30 to 70 $\mu$m, a width ranging from 100 - 5000 $\mu$m, preferably from 1000 to 2000 $\mu$m, and a length ranging from 0.3 - 5 cm, preferably from 0.5 to 1.5 cm.

7. A method as claimed in any of claims 1 to 6 wherein the film is provided by roll-to-toll processing, doctor blading or preferably spin coating of dissolved conductive polymer.

8. A method as claimed in any of claims 1 to 7 wherein the film is provided by spin coating.

9. A method as claimed in claim 8 wherein first single layer of conductive polymer is obtained by spin coating, and thicker layers are obtained by repeating the spin coating process multiple times in order to reach a desired thickness.

10. A method as claimed in any of claims 1 to 9 wherein the fluid is a secondary dopant of conductive polymer or a solution of such secondary dopant wherein the secondary dopant is selected from one or more of the group comprising :

    - High boiling point solvents (e.g. dimethylsulfoxide, tetrahydrofurane, dimethylformamide, acetonitrile, nitromethane, pyridine)
    - Alcohols (e.g. ethylene glycol, diethylene glycol, glycerol, methanol, 4-methoxyphenol)
    - Ionic liquids (e.g. 1-ethyl-3-methylimidazolium tetracyanoborate, EMIM-TCB; 2-methylimidazole; 1-ethyl-3-methylimidazolium tetrafluoroborate, EMIM-BF$_4$)
    - Inorganic acids (e.g. sulfuric acid)
    - Weak and mild organic acids (e.g. methanesulfonic acid)

11. A method as claimed in claims 10 wherein the secondary dopant is ethylene glycol, dimethyl sulfoxide or EMIM-TCB.

12. A method as claimed in any of claims 1 to 11 wherein each microchannel is equipped with an inlet and an outlet.

13. Highly conductive track in films of conductive polymer obtained by the method as claimed in any of claims 1 - 12.

14. Transparent electronic device comprising highly conductive tracks as claimed in claim 13.

15. Use of highly conductive tracks as claimed in claim 13 as microheaters.

16. Use of the microfluidics technique to locally tune the conductive properties of conductive polymer film.

Figure 1

EP 3 444 672 A1

Figure 2

a)

b)

EP 3 444 672 A1

Figure 3

a) Temperature (°C)

b)

EP 3 444 672 A1

Figure 4

PEDOT:PSS
EG
DMSO
EMIMTCB

Raman Shift (cm$^{-1}$)

Normalised Intensity

Figure 5

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/117723 A1 (SEIDEL ROBERT [DE] ET AL) 19 May 2011 (2011-05-19)<br><br>* paragraphs [0006], [0029] - [0034]; claims 1-20; figure 1 * | 1,3,5-7, 10,13, 14,16 | INV.<br>G03F7/00 |
| Y | US 2009/046362 A1 (GUO LINGJIE JAY [US] ET AL) 19 February 2009 (2009-02-19)<br>* paragraphs [0126], [0127]; figure 15 * | 1-14 | |
| X | US 2016/268056 A1 (KIM MIKYOUNG [KR]) 15 September 2016 (2016-09-15) | 16 | |
| Y | * paragraphs [0004], [0007], [0010] - [0012], [0016], [0031] - [0041]; claims 1-15 * | 1-14 | |
| X | WO 2014/090394 A1 (STICHTING MATERIALS INNOVATION INST M2I [NL]) 19 June 2014 (2014-06-19) | 16 | |
| Y | * claims 1-26 * | 1-14 | |
| A | US 2015/352586 A1 (KIM SEOK [US] ET AL) 10 December 2015 (2015-12-10)<br>* paragraphs [0061] - [0064] * | 1-16 | TECHNICAL FIELDS SEARCHED (IPC)<br><br>G03F<br>H01L<br>C09D |

The present search report has been drawn up for all claims

| Place of search | Date of completion of the search | Examiner |
|---|---|---|
| Munich | 7 February 2018 | Mingam, Claudie |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 17 30 6071

This annex lists the patent family members relating to the patent documents cited in the above-mentioned European search report.
The members are as contained in the European Patent Office EDP file on
The European Patent Office is in no way liable for these particulars which are merely given for the purpose of information.

07-02-2018

| Patent document cited in search report | | Publication date | Patent family member(s) | | Publication date |
|---|---|---|---|---|---|
| US 2011117723 | A1 | 19-05-2011 | CN | 101479842 A | 08-07-2009 |
| | | | DE | 102006030267 A1 | 03-01-2008 |
| | | | GB | 2452445 A | 04-03-2009 |
| | | | JP | 5244793 B2 | 24-07-2013 |
| | | | JP | 2009543334 A | 03-12-2009 |
| | | | KR | 20090033464 A | 03-04-2009 |
| | | | TW | 200816303 A | 01-04-2008 |
| | | | US | 2008003818 A1 | 03-01-2008 |
| | | | US | 2011117723 A1 | 19-05-2011 |
| US 2009046362 | A1 | 19-02-2009 | US | 2009046362 A1 | 19-02-2009 |
| | | | WO | 2008124180 A1 | 16-10-2008 |
| US 2016268056 | A1 | 15-09-2016 | CN | 105723472 A | 29-06-2016 |
| | | | JP | 6101869 B2 | 22-03-2017 |
| | | | JP | 2016533003 A | 20-10-2016 |
| | | | KR | 20150041971 A | 20-04-2015 |
| | | | US | 2016268056 A1 | 15-09-2016 |
| | | | WO | 2015071794 A1 | 21-05-2015 |
| WO 2014090394 | A1 | 19-06-2014 | NONE | | |
| US 2015352586 | A1 | 10-12-2015 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **TAKAMATSU, S. et al.** *Scientific Reports,* 2015, vol. 5, 15003
- **PAL, R.K. et al.** *Adv. Mater.,* 2016, vol. 28, 1406-1412
- **ZHANG S. et al.** *J. Mater. Chem. C,* 2016, vol. 4, 1382-1385
- *Microsyst. Technol.,* 2013, vol. 19, 895-903
- **KIM, N. et al.** *Adv. Mater.,* 2015, vol. 27, 2317-2323
- **XIONG, Z. ; LIU, C.** *Organic Electronics,* 2012, vol. 13, 1532-1540
- **SELE, C.W. et al.** *Adv. Mater.,* 2005, vol. 17, 997-1001
- **KIM, S. et al.** *Organic Electronics,* 2016, vol. 30, 296-301
- **SEMALTIANOS, N.G. et al.** *Synthetic Metals,* 2011, vol. 161, 431-439